# EUROPEAN PATENT APPLICATION

(11) **EP 3 089 288 A1**
(43) Date of publication of application: **02.11.2016**
(21) Application number: 15305669.2
(22) Date of filing: 30.04.2015
(51) Int. Cl.: H01S 5/50, H01S 5/0625, H01S 5/00, H01S 5/30

(54) **OPTICAL DEVICE WITH MULTISECTION SOA FOR ACHIEVING WIDE OPTICAL BANDWIDTH AND LARGE OUTPUT POWER**

(71) Applicant: ALCATEL LUCENT, 92100 Boulogne-Billancourt (FR); COMMISSARIAT A L'ENERGIE ATOMIQUE ET AUX ENERGIES ALTERNATIVES, 75015 Paris (FR)
(72) Inventor: Brenot, Romain, 91767 PALAISEAU (FR); Faugeron, Mickaël, 92120 MONTROUGE (FR)
(74) Representative: Novagraaf Technologies

(57) **Abstract**

An optical device (10) comprises a first semiconductor optical amplifier (1) comprising an active region (3) embedded into a waveguide (2) and comprising a first section (3₁) intended for amplifying optical signals when it is crossed by a first current smaller than a chosen value inducing amplification over a large optical bandwidth, and a second section (3₂) intended for amplifying the optical signals amplified by the first section (3₁) when it is crossed by a second current greater than this chosen value, to deliver output optical signals with a large power.

## Description

### Field of the Invention

The present invention relates to optical devices defining Semiconductor Optical Amplifiers (or SOAs).

### Background

In some technical domains, such as telecommunication optical networks, optical amplifiers are important devices that allow optical signals to be transmitted over long distances. To increase the transmission capacity of optical fibres, it has been proposed to use Semiconductor Optical Amplifiers (or SOA) because their gain bandwidth is generally two times greater than the one of the currently used Erbium Doped Fiber Amplifiers (or EDFAs).

Actually there exists two main types of SOA: the polarization sensitive SOA and the polarization insensitive SOA.

Polarization sensitive SOAs offer an output power that is limited to 17 dBm, which is too low for practical applications and notably in telecommunication optical networks.

Polarization insensitive SOAs allow achieving a large output power. An example of polarization insensitive SOA is described in the document of K. Morito and S. Tanaka, "Record High Saturation Power (+22 dBm) and Low Noise Figure (5.7 dB) Polarization-Insensitive SOA Module," IEEE Photon. Technol. Lett., vol. 17, no. 6, pp. 1298-1300, June 2005. However, the optical bandwidth appears to be quite low (typically 50 to 60 nm).

Therefore there is no solution that allows achieving a wide optical bandwidth and a large output power with a SOA.

### Summary

So an object of this invention is to improve the situation.

In an embodiment, an optical device comprises a first semiconductor optical amplifier comprising an active region embedded into a waveguide and comprising at least a first section intended for amplifying optical signals when it is crossed by a first current smaller than a chosen value inducing amplification over a large optical bandwidth, and a second section intended for amplifying the optical signals amplified by the first section when it is crossed by a second current greater than this chosen value, to deliver output optical signals with a large power.

This allows achieving an optical device with wide optical bandwidth (due to the in-line combination of first and second sections respectively crossed by first and second currents) and large output power (due to the very high carrier density induced by the second current).

The optical device may include additional characteristics considered separately or combined, and notably:
- the first and second sections may have approximately a same length;
- in a first variant of embodiment, the active region of the first semiconductor optical amplifier may comprise a third section located upward the first section and intended for preamplifying input optical signals when it is crossed by a third current approximately equal to the chosen value, in order to feed the first section with preamplified optical signals;
- the first, second and third sections may have approximately a same length;
- in a second variant of embodiment, it may further comprise a second semiconductor optical amplifier comprising an active region embedded into a waveguide and intended for preamplifying input optical signals when it is crossed by a third current approximately equal to the chosen value, in order to output preamplified optical signals, and a variable optical attenuator located between the second and first semiconductor optical amplifiers and coupled to monitoring photodiodes also coupled to input and output of the second and first semiconductor optical amplifiers, and arranged for controlling the power of the outputted preamplified optical signals depending on the power of the input optical signals, to feed the first section of the active region of the first semiconductor optical amplifier with optical signals having an approximately constant power;
- the first and second sections of the active region of the first semiconductor optical amplifier and the active region of the second semiconductor optical amplifier may have approximately a same length;
- each active region may comprise multiple quantum wells;
- each active region may comprise a multiplicity of strained InGaAsP quantum wells or materials containing aluminium.

### Brief Description of the Figures

Some embodiments of an optical device in accordance with embodiments of the present invention are now described, by way of example only, and with reference to the accompanying drawings, in which:
- Figure 1 schematically illustrates, in cross section view, a first example of embodiment of an optical device according to the invention,
- Figure 2 schematically illustrates the gain profile (in dB) of the optical device of Figure 1 as a function of the wavelength (in nm),
- Figure 3 schematically illustrates, in cross section view, a second example of embodiment of an optical device according to the invention, and
- Figure 4 schematically illustrates, in cross section view, a third example of embodiment of an optical device according to the invention.

### Description of Embodiments

Hereafter is notably disclosed an optical device intended for amplifying optical signals, having wavelengths belonging to a wide optical bandwidth, to output optical signals with large power.

In the following description it will be considered that the optical device is intended for equiping a telecommunication optical network. But this is not mandatory. Indeed, an optical device may equip any apparatus, device or system in which optical signals, having wavelengths belonging to a wide optical bandwidth, need to be amplified. For instance, the invention may be used also to design wide bandwidth and large power Super-Luminescent Diodes (or SLD).

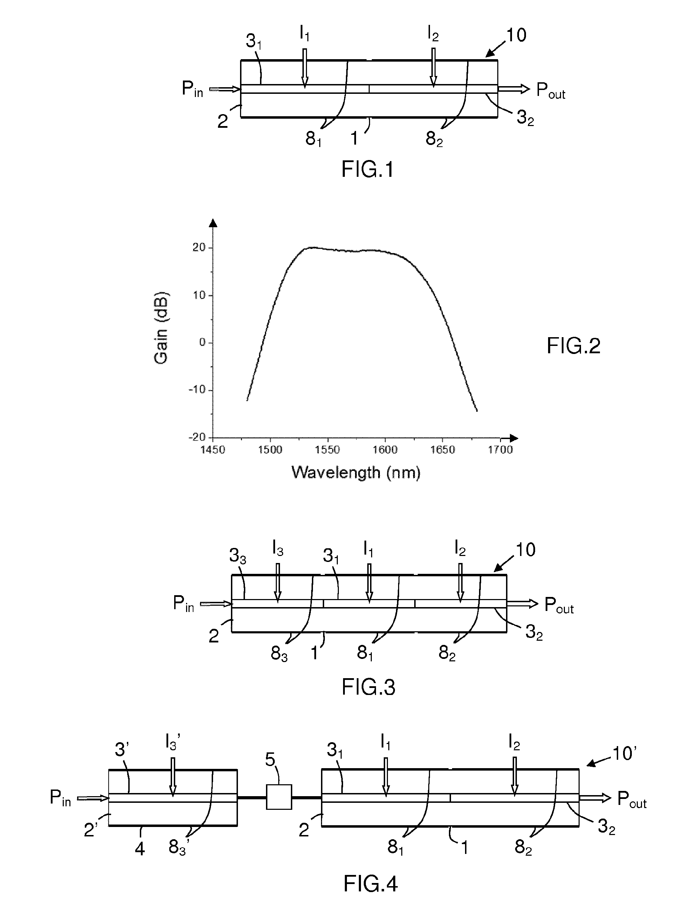

A first example of embodiment of an optical device 10 according to the invention is illustrated in Figure 1.

As illustrated, an optical device 10, according to the invention, comprises at least a first semiconductor optical amplifier 1 comprising an active region 3 embedded into a waveguide 2 and comprising at least first 3₁ and second 3₂ sections. The first section 3₁ is intended for amplifying optical signals when it is crossed by a first current I₁ that is smaller than a chosen value I_{T} inducing amplification over a large optical bandwidth. The second section 3₂ is intended for amplifying the optical signals amplified by the first section 3₁ when it is crossed by a second current I₂ that is greater than the chosen value I_{T}, to deliver output optical signals with a large power.

Each section 3ⱼ (j = 1 or 2) is associated to a couple of electrodes 8ⱼ that are intended for being connected to an electronic circuit intended for providing it with its current Iⱼ. So, the first current I₁ (j = 1) crosses the first section 3₁ via the couple of electrodes 8₁, while the second current I₂ (j = 2) crosses the second section 3₂ via the couple of electrodes 8₂.

The expression "greater" means that the second current I₂ is preferably at least 20% greater than the chosen value I_{T} that induces an amplification over a large optical bandwidth.

The resulting gain of the first 3₁ and second 3₂ sections is the product of the gain of each section.

For instance, the active region 3 may comprise multiple quantum wells (or MQW). In this case, the active region 3 preferably comprises a multiplicity of strained InGaAsP quantum wells. This type of active region is described (with different parameters) in the document of H. Carrère et al., "Large optical bandwidth and polarization insensitive semiconductor optical amplifiers using strained InGaAsP quantum wells," Appl. Phys. Lett., 97, 121101, 2010. As described in this document, this type of active region allows achieving a large optical bandwidth, typically greater than 100 nm, when the carrier density created into the active region by the injected current becomes approximately (i.e. more or less) equal to a density value that depends from the above mentioned chosen value I_{T}. But the output power of such an active region is quite low (typically 15 dBm).

But thank to the invention, when the active region 3 is divided in at least two successive sections 3ⱼ, with the last one crossed by a second current I₂ greater than the chosen value I_{T} (I₂ >> I_{T}), it offers a large output power Pout that may be greater than 20 dBm because this output power mainly depends from the carrier density in the second (and last) section 3₂. So, the optical device 10 offers a wide optical bandwidth (due to the in-line combination of first 3₁ and second 3₂ sections) and a large output power Pout (due to the very high carrier density induced by the second current I₂), as illustrated in the diagram of Figure 2. In Figure 2 the gain is representative of the amplification factor of the output optical signals.

In a variant of embodiment the active region 3 may comprise materials containing aluminium.

The first 3₁ and second 3₂ sections (and therefore there respective electrodes 8ⱼ) may have approximately a same length in order the gain (or amplification factor) be approximately flat. But other configurations are possible.

Since the carrier density is relatively low in the first section 3₁, the noise figure (or NF) of the optical device 10 is large at low wavelength. This results from the fact that NF is governed by the carrier density at the input of the optical device 10. To overcome this drawback, and to be able to control the output power Pout and possibly the gain tilt whatever the input power Pᵢₙ of the input optical signals, it is of interest to increase the carrier density upward the first section 3₁. At least two solutions can be envisaged to obtain such an increase.

A first solution is illustrated in the non-limitating example of Figure 3. It consists in adding a third section 3₃ to the active region 3 of the first semiconductor optical amplifier 1 upward the first section 3₁. This third section 3₃ is intended for preamplifying the input optical signals when it is crossed by a third current I₃ that is approximately equal to the chosen value I_{T}, in order to feed the first section 3₁ with preamplified optical signals.

This third section 3₃ (j = 3) is associated to a couple of electrodes 8₃ that are intended for being connected to an electronic circuit intended for providing it with its third current I₃. So, the third current I₃ crosses the third section 3₃ via the couple of electrodes 8₃.

The first 3₁, second 3₂ and third 3₃ sections (and therefore there respective electrodes 8ⱼ) may have approximately a same length in order the gain (or amplification factor) be approximately flat. But other configurations are possible.

Moreover, this third section 3₃ being a part of the active region 3 it comprises preferably a multiplicity of strained InGaAsP quantum wells, as mentioned before.

This first solution allows decreasing the noise figure of the optical device 10 at low wavelength, but it does not allow controlling the gain tilt.

To be also able to control the gain tilt while decreasing the noise figure, it is preferable to use two amplifications "stages" as illustrated in the non limiting example of Figure 4. This second solution consists in adding a second semiconductor optical amplifier 4 and a variable optical attenuator 5 associated to monitoring photodiodes to the first semiconductor optical amplifier 1 to obtain another optical device 10'. The second semiconductor optical amplifier 4 defines the first amplification stage, while the first semiconductor optical amplifier 1 defines the second amplification stage.

This second semiconductor optical amplifier 4 comprises an active region 3' embedded into a waveguide 2' and intended for preamplifying the input optical signals when it is crossed by a third current I₃' approximately equal to the chosen value I_{T}, in order to output preamplified optical signals.

This active region 3' is associated to a couple of electrodes 8₃' that are intended for being connected to an electronic circuit intended for providing it with its third current I₃'. So, the third current I₃' crosses the active region 3' via the couple of electrodes 8₃'.

For instance, the first 3₁ and second 3₂ sections of the active region 3 of the first semiconductor optical amplifier 1 and the active region 3' of the second semiconductor optical amplifier 4 may have approximately a same length in order the gain (or amplification factor) be approximately flat. But other configurations are possible.

Also for instance the active region 3' comprises preferably a multiplicity of strained InGaAsP quantum wells. But in a variant of embodiment this active region 3' may comprise materials containing aluminium.

The variable optical attenuator 5 is located between the second 4 and first 1 semiconductor optical amplifiers and coupled to monitoring photodiodes (not illustrated in the Figures) that are also coupled to input and output of the second 4 and first 1 semiconductor optical amplifiers.

This combination of variable optical attenuator 5 and monitoring photodiodes is arranged for controlling the power of the outputted preamplified optical signals depending on the power of the input optical signals, to feed the first section 3₁ of the active region 3 of the first semiconductor optical amplifier 1 with optical signals having an approximately constant power.

Depending on the application requirements, one can either use the first (Figure 3) or second (Figure 4) solution.

Compared to EDFA, an optical device according to the invention allows multiplying the optical bandwidth by at least three (> 100 nm), while offering a large output power (> 20 dBm), which potentially triples the capacity of optical fibres.

It should be appreciated by those skilled in the art that any block diagram herein represent conceptual views of illustrative circuitry embodying the principles of the invention.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Optical device (10; 10') comprising a first semiconductor optical amplifier (1) comprising an active region (3) embedded into a waveguide (2) and comprising at least a first section (3₁) intended for amplifying optical signals when it is crossed by a first current smaller than a chosen value inducing amplification over a large optical bandwidth, and a second section (3₂) intended for amplifying the optical signals amplified by said first section (3₁) when it is crossed by a second current greater than said chosen value, to deliver output optical signals with a large power.

2. Optical device according to claim 1, wherein said first (3₁) and second (3₂) sections have approximately a same length.

3. Optical device according to one of claims 1 and 2, wherein said active region (3) of said first semiconductor optical amplifier (1) comprises a third section (3₃) located upward said first section (3₁) and intended for preamplifying input optical signals when it is crossed by a third current approximately equal to said chosen value, in order to feed said first section (3₁) with preamplified optical signals.

4. Optical device according to claim 3, wherein said first (3₁), second (3₂) and third (3₃) sections have approximately a same length.

5. Optical device according to one of claims 1 and 2, wherein it further comprises i) a second semiconductor optical amplifier (4) comprising an active region (3') embedded into a waveguide (2') and intended for preamplifying input optical signals when it is crossed by a third current approximately equal to said chosen value, in order to output preamplified optical signals, and ii) a variable optical attenuator (5) located between said second (4) and first (1) semiconductor optical amplifiers and coupled to monitoring photodiodes also coupled to input and output of said second (4) and first (1) semiconductor optical amplifiers, and arranged for controlling the power of the outputted preamplified optical signals depending on the power of the input optical signals, to feed said first section (3₁) of said active region (3) of said first semiconductor optical amplifier (1) with optical signals having an approximately constant power.

6. Optical device according to the combination of claims 2 and 5, wherein said first (3₁) and second (3₂) sections of said active region (3) of said first semiconductor optical amplifier (1) and said active region (3') of said second semiconductor optical amplifier (4) have approximately a same length.

7. Optical device according to one of claims 1 to 6, wherein said active region (3; 3') comprises multiple quantum wells.

8. Optical device according to claim 7, wherein said active region (3; 3') comprises a multiplicity of strained InGaAsP quantum wells.

## Amended claims

### Amended claims in accordance with Rule 137(2) EPC.

1. Optical device (10; 10') comprising a first semiconductor optical amplifier (1) comprising an active region (3) embedded into a waveguide (2) and comprising at least a first section (3₁) intended for amplifying optical signals when it is crossed by a first current smaller than a chosen value, said chosen value inducing amplification over a large optical bandwidth, and a second section (3₂) intended for amplifying the optical signals amplified by said first section (3₁) when it is crossed by a second current greater than said chosen value, to deliver output optical signals with a large power.

2. Optical device according to claim 1, wherein said first (3₁) and second (3₂) sections have approximately a same length.

3. Optical device according to one of claims 1 and 2, wherein said active region (3) of said first semiconductor optical amplifier (1) comprises a third section (3₃) located upward said first section (3₁) and intended for preamplifying input optical signals when it is crossed by a third current approximately equal to said chosen value, in order to feed said first section (3₁) with preamplified optical signals.

4. Optical device according to claim 3, wherein said first (3₁), second (3₂) and third (3₃) sections have approximately a same length.

5. Optical device according to one of claims 1 and 2, wherein it further comprises i) a second semiconductor optical amplifier (4) comprising an active region (3') embedded into a waveguide (2') and intended for preamplifying input optical signals when it is crossed by a third current approximately equal to said chosen value, in order to output preamplified optical signals, and ii) a variable optical attenuator (5) located between said second (4) and first (1) semiconductor optical amplifiers and coupled to monitoring photodiodes also coupled to input and output of said second (4) and first (1) semiconductor optical amplifiers, and arranged for controlling the power of the outputted preamplified optical signals depending on the power of the input optical signals, to feed said first section (3₁) of said active region (3) of said first semiconductor optical amplifier (1) with optical signals having an approximately constant power.

6. Optical device according to the combination of claims 2 and 5, wherein said first (3₁) and second (3₂) sections of said active region (3) of said first semiconductor optical amplifier (1) and said active region (3') of said second semiconductor optical amplifier (4) have approximately a same length.

7. Optical device according to one of claims 1 to 6, wherein said active region (3; 3') comprises multiple quantum wells.

8. Optical device according to claim 7, wherein said active region (3; 3') comprises a multiplicity of strained InGaAsP quantum wells.
